# EUROPÄISCHE PATENTANMELDUNG

(11) **EP 0 786 864 A1**
(43) Veröffentlichungstag der Anmeldung: **30.07.1997**
(21) Anmeldenummer: 97100499.9
(22) Anmeldetag: 15.01.1997
(51) Int. Cl.: H03J 1/00

(54) **Tuner für den Empfang digitaler Signale**

(30) Priorität: 25.01.1996 DE 19602573
(71) Anmelder: GRUNDIG Aktiengesellschaft, 90762 Fürth (DE)
(72) Erfinder: Eich, Manfred, Kurgartenstrasse 37, 90762 Fürth (DE)

(57) **Zusammenfassung**

Bekannte abgleichbare Tuner sind für den Empfang analoger Signale gut geeignet, sie weisen jedoch den Nachteil auf, daß beim Empfang digitaler Signale große Probleme auftreten können. Diese Probleme ergeben sich aus der Eigenschaft der digitalen Signale, daß sie, falls beim Empfang eine gewisse Bitfehlerrate überschritten wird, nicht mehr decodierbar sind. Die Probleme im Tuner werden durch verschiedene Einflüsse verursacht, die beim herstellungsseitigen Abgleich nicht berücksichtigt werden können. Beispielsweise durch einen Fehlabschluß des Antenneneingangs wegen der Verwendung eines ungeeigneten Antennenkabels, wodurch der Vorkreis des Tuners verstimmt wird, so daß die optimale Durchlaßkurve des Tuners nicht erreicht werden kann. Weitere Probleme stellten Temperaturgang oder die Regelung der Tunervorstufe durch die automatische Verstärkungsregelung (AGC) dar, die ebenfalls zu einer Verschlechterung der Durchlaßkurve führen können.

Bei der vorliegenden Erfindung werden diese Probleme dadurch gelöst, daß ausgehend von dem bereits herstellungsseitig durchgeführten Abgleich durch einen einzeln anpaßbaren Kreis des Tuners eine Anpassung für jeden Kanal an die jeweils vorliegenden Betriebsparameter erfolgen kann, ohne daß eine aufwendige Abstimmung aller vorhandenen Kreise in mehreren, iterativen Schritten erfolgen muß. Somit kann allein durch die Anpassung eines Kreises die optimale Durchlaßkurve des Tuner nahezu erreicht werden, wodurch der ordnungsgemäße Empfang digitaler Signale auch mit einem einfachen Tuner erreicht werden kann.

## Beschreibung

Die Erfindung betrifft einen Tuner für den Empfang digitaler Signale, mit den Merkmalen des Oberbegriffs nach Anspruch 1.

Aus der Offenlegungsschrift EP 0 044 237 A1 ist die Abstimmung eines elektronischen Schaltkreises, insbesondere eines Fernsehempfängers, mit mehreren variablen Elementen bekannt. Dieses Dokument erwähnt insbesondere die Abstimmung eines Filters oder eines Oszillators mit Kapazitätsdioden. Die bekannte Abgleichvorrichtung enthält einen bereits zum Zeitpunkt der Herstellung festprogrammierten Speicher (z.B. EPROM), der als Funktion der Kennlinien der variablen Elemente programmiert wird, um beispielsweise Eingriffe des Benutzers zu vermeiden. Die abgespeicherten Informationen dienen für die Erzeugung der Steuersignale für die elektronischen Mittel zur Abstimmung. Hierzu werden Abgleichwerte an die Abgleichvorrichtung angelegt und die einzelnen Abgleichgrößen ausgelesen. Im bekannten Falle geht es im wesentlichen darum, daß im festprogrammierten Speicher Platz gespart wird, was durch eine Abspeicherung der einzelnen Differenzen der Abgleichgrößen zueinander erfolgt.

Bei bekannten elektronisch abstimmbaren selektiven Verstärkern, insbesondere Tunern, werden in den Vor-, Drain-, Misch- und Oszillatorkreisen meist spannungsgesteuerte variable Reaktanzelemente (Kapazitätsdioden) zur Abstimmung verwendet. Dort werden den für die Abstimmung verwendeten Kapazitätsdioden getrennte und voneinander unabhängig veränderbare Abstimmspannungen zugeführt. Jeweils nach Watt) eines neuen Frequenzkanals wird der Tuner von einem Mikroprozessor mit Hilfe der unabhängig veränderbaren Abstimmspannungen automatisch abgeglichen. Hierzu trennt zunächst der Mikroprozessor die Antenne vom Eingang des Vorkreises und koppelt anstelle des Antennensignals das Ausgangssignal des von einer PLL gesteuerten Oszillators in den Vorkreis ein. Dabei entspricht die Frequenz dieses Signals der vorher gewählten Kanalfrequenz. Der Abgleich der einzelnen Kreise erfolgt nacheinander durch Variation der dem jeweiligen Abstimmelement zugeführten Abstimmspannung. Ein am Ausgang des letzten Kreises angeschlossener Detektor kontrolliert den Pegel der Signaldurchlaßkurve und veranlaßt die Beendigung des jeweiligen Abgleichschrittes, sobald ein Maximum der Signaldurchlaßkurve auftritt. Nach Beendigung des gesamten Abgleichvorganges trennt der Mikroprozessor den Oszillator wieder vom Eingang des Vorkreises und schaltet die Antenne an den betreffenden Eingang an. Die vorher ermittelten Abstimmspannungen werden in einem Kurzzeitspeicher digital abgelegt und bei der Wahl eines anderen Kanals wieder gelöscht (US 4,334,323).

Die Nachteile dieses Tuners liegen zum einen in der relativ aufwendigen Abgleicheinheit, die zudem gesondert in den Tuner bzw. jedes Rundfunk- oder Fernsehgerät eingebaut werden muß und damit höhere Gerätekosten verursacht. Zum anderen muß sich der Tuner jeweils nach der Wahl eines anderen Kanals wieder neu abgleichen, da die Abstimmdaten für die einzelnen Kanäle nicht abrufbereit gespeichert werden. Im übrigen wäre eine Speicherung der Abstimmdaten mit einem hohen kostenmäßigen und technischen Aufwand an Speicherkapazität verbunden, falls für jeden wählbaren Frequenzkanal mehrere Abstimmspannungen abgespeichert werden sollen.

Aus der Patentschrift EP 0 147 518 B1 ist ein Tuner bekannt, bei dem die Abstimmdioden der Vor-, Drain-, Misch- und Oszillatorkreise in bekannter Weise von getrennt veränderbaren Abstimmspannungen angesteuert werden. Jedoch erfolgt der Abgleich des selektiven Verstärkers im Gegensatz zu den bekannten Verfahren über eine extern an den Verstärker anschließbare wahlweise automatische oder manuell betätigbare Abgleichvorrichtung. Diese Abgleichvorrichtung enthält im Unterschied zu dem Bekannten einen Zwischenspeicher zur Zwischenspeicherung der in iterativen Abgleichschritten gewonnenen Abgleichwerte für die einzelnen Reaktanzelemente, während der selektive Verstärker selbst mit einem nichtflüchtigen Speicher ausgestattet ist, in den die Abgleichvorrichtung nach beendetem Abgleich die optimierten Abgleichwerte überträgt. Diese Abgleichwerte sind dann für den späteren Betriebszustand des Verstärkers permanent gespeichert.

Alle bekannten abgleichbaren Tuner sind für den Empfang analoger Signale gut geeignet, sie weisen jedoch den Nachteil auf, daß beim Empfang digitaler Signale, insbesondere digitaler Rundfunk- oder Fernsehsignale, die beispielsweise quadraturamplitudenmoduliert sind, große Probleme auftreten können. Diese Probleme ergeben sich aus der Eigenschaft der digitalen Signale, daß sie, falls beim Empfang eine gewisse Bitfehlerrate überschritten wird, nicht mehr decodierbar sind. Die Probleme im Tuner werden durch verschiedene Einflüsse verursacht, die beim herstellungsseitigen Abgleich nicht berücksichtigt werden können. Beispielsweise durch einen Fehlabschluß des Antenneneingangs wegen der Verwendung eines ungeeigneten Antennenkabels, wodurch der Vorkreis des Tuners verstimmt wird, so daß die optimale Durchlaßkurve des Tuners nicht erreicht werden kann. Weitere Probleme stellten Temperaturgang oder die Regelung der Tunervorstufe durch die automatische Verstärkungsregelung (AGC) dar, die ebenfalls zu einer Verschlechterung der Durchlaßkurve führen können.

Neben den oben beschriebenen Tunern sind auch sogenannte Doppelkonversionstuner bekannt, die zum Empfang digitaler Signale geeignet sind. Die Doppelkonversionstuner weisen aber den Nachteil auf, daß aufwendig und somit teuer sind.

Aufgabe der vorliegenden Erfindung ist es deshalb, einen Tuner für digitale Signale anzugeben, der mit geringem Aufwand realisert werden kann und bei dem die eingangs beschriebenen Probleme vermieden werden.

Erfindungsgemäß wird diese Aufgabe durch die Merkmale des Anspruchs 1 gelöst.

Der Vorteil der Erfindung liegt insbesondere darin, daß ausgehend von dem bereits herstellungsseitig durchgeführten Abgleich durch einen einzeln anpaßbaren Kreis des Tuners eine Anpassung für jeden Kanal an die jeweils vorliegenden Betriebsparameter erfolgen kann, ohne daß eine aufwendige Abstimmung aller vorhandenen Kreise in mehreren, iterativen Schritten erfolgen muß. Somit kann allein durch die Anpassung eines Kreises die optimale Durchlaßkurve des Tuner nahezu erreicht werden, wodurch der ordnungsgemäße Empfang digitaler Signale auch mit einem einfachen Tuner erreicht werden kann.

Weitere Vorteile der Erfindung ergeben sich aus den abhängigen Ansprüchen sowie der nachfolgenden Beschreibung der Erfindung anhand von Figuren.

Es zeigt:
Figur 1 ein Blockschaltbild einer Ausführungsform eines erfindungsgemäßen Tuners,
Figur 2 ein Blockschaltbild einer Empfängeranordnung für digitale Signale, die einen erfindungsgemäßen Tuner aufweist, und
Figur 3 verschiedene Durchlaßkurven von Tunern.

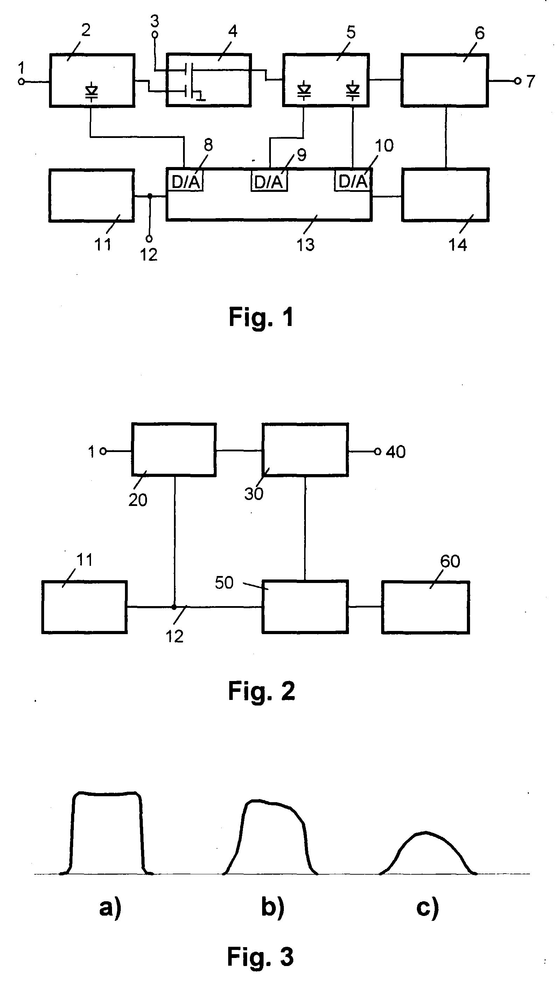

Der in Figur 1 dargestellte Tuner weist einen abgleichbaren Vorkreis 2, eine Vorstufe 4, die von einer automatischen Verstärkungsregelung (AGC) 3 gesteuert wird, ein abgleichbares Bandfilter 5, einen Mischer 6, einen nichtflüchtigen Speicher 11, der auch Bestandteil eines Mikrocomputers sein kann, eine Phasenvergleichsschaltung (PLL) 13 mit drei Digital/Analog-Wandlern 8, 9, 10 und einen spannungsgesteuerten Oszillator (VCO) 14 auf.

In Figur 2 ist eine Empfangsanordnung für digitale Signale dargestellt, die neben einem wie in Figur 1 dargestellten Tuner 20, einen Demodulator 40 für digitale Signale, eine Steuereinheit 50, die beispielsweise von einem Mikrocomputer gebildet werden kann, eine Bedieneinheit 60, die beispielsweise eine Tastatur oder eine Fernbedienung sein kann, und den bereits erwähnten Speicher 11 enthält.

Am Eingang 1 liegt ein hochfrequentes digitales Signal an, das beispielsweise von einer Antenne oder einem Kabel stammt. Mittels Vorkreis 2, Vorstufe 4, Mischer 6 und VCO 14 wird in bekannter Weise ein Zwischenfrequenzsignal erzeugt, das das Signal des gewählten Kanals enthält und am Ausgang 7 zur Verfügung steht. Die Auswahl eines bestimmten Kanals erfolgt mittels der Bedieneinheit 60, gesteuert von der Steuereinheit 50, über einen Steuerbus 12, der beispielsweise einem I²C-Bus geblidet werden kann. Das Zwischenfrequenzsignal wird von dem Demodulator 30 verarbeitet und der gewonnene Datenstrom steht zur weiteren Auswertung zur Verfügung. Der Abstimmvorgang für den Empfang einzelner Kanäle erfolgt in an sich bekannter Weise durch Verwendung der im Speicher 11 gespeicherten Abgleichwerte für die einzelnen veränderbaren Reaktanzelemente von Vorkreis 2, Bandfilter 5 und Oszillator 14, wobei die aus dem Speicher 11 stammenden Werte für die einzelnen Reaktanzelemente von den Digital/Analog-Wandlern 8, 9, 10 in Steuerspannungen umgesetzt werden (siehe beispielsweise oben erwähnte EP 0 147 518 B1).

Entsprechen die Betriebsbedingungen des Tuners den beim herstellungsseitigen Abgleich zugurndegelegten Bedingungen, ergibt sich die optimale Durchlaßkurve für den Tuner wie in Figur 3a dargestellt. Liegt ein Fehlabschluß des Antenneneingangs 1 oder Temperaturgang vor, wird die Durchlaßkurve wie in Figur 3b dargestellt verändert. Durch das Einsetzen der Regelung der Vorstufe durch die AGC wird die Durchlaßkuve wie in Figur 3c dargestellt verändert. Bei den in den Figuren 3b und c dargestellten Durchlaßkurven kann es zum vollständigen Ausfall des Signals kommen, wenn die oben beschriebene kritische Bitfehlerrate überschritten wird, da dann die Decodierung des digitalen Signals nicht mehr möglich ist.

Ist das digitale Signal eines Kanals nicht decodierbar, können die Abgleichwerte des Vorkreises 2 von der Steuereinheit 50 verändert und über den Steuerbus 12 an den Digital/Anaolg-Wandler 8 gegeben, wodurch die Durchlaßkurve des Vorkreises 2 und somit die resultierende Durchlaßkurve des Tuners (resultiert aus Vorkreis 2, Vorstufe 4, Bandfilter 5 und Oszillator 14) verändert wird. Die Veränderung wird mittels der Bedieneinheit 60 gestartet. Die Abgleichwerte können mittels der Bedieneinheit 60 entweder schrittweise verkleinert oder vergrößert werden, bis das digitale Signal decodiert werden kann (Kontrolle beispielsweise durch dann mögliche Wiedergabe des digitalen Bild- oder Tonsignals) oder die Abgleichwerte werden von der Steuereinheit 50 automatisch schrittweise so lange verkleinert oder vergrößert bis über die Bedieneinheit ein Stoppbefehl eingegeben wird. Der zuletzt eingestellte Abgleichwert wird dann im Speicher 11 als Korrekturwert für den jeweiligen Kanal abgespeichert. Besonders vorteilhaft ist es, die Korrekturwerte als Differenz zu den herstellungsseitig ermittelten und gespeicherten Abgleichwerten für den Vorkreis im Speicher 11 zu speichern. Wird der so korrigierte Kanal erneut aufgerufen, wird der Vorkreis 2 mittels Abgleichwert und Korrekurwert aus Speicher 11 abgeglichen.

Für den Fall, daß sich die Betriebsbedingungen insgesamt ändern, beispielsweise bei Anschluß an eine andere Antennenleitung nach einem Umzug, kann ein Befehl vorgesehen werden, mit dem die Korrekturwerte im Speicher 11 gelöscht werden können, so daß wieder allein die beim herstellungsseitigen Abgleich ermittelten Abgleichwerte aus dem Speicher 11 verwendet werden.

Neben der beschriebenen manuellen Einstellung der Korrekturwerte, kann auch eine automatische Einstellung vorgenommen werden. Dazu muß, beispielsweise im Demodulator 30, eine Einrichtung zur Ermittlung der Bitfehlerrate vorhanden sein. Diese Einrichtung ermittelt die jeweils auftretende Bitfehlerrate und gibt diese an die Steuereinheit 50 weiter. Wird ein vorgegebener Grenzwert überschritten, leitet die Steuereinheit 50 eine Anpassung des Vorkreises 2 ein. Dazu werden die Abgleichwerte von der Steuereinheit verändert und über den Steuerbus 12 an den Digital/Anaolg-Wandler 8 gegeben, wodurch die Durchlaßkurve des Vorkreises 2 und somit die resultierende Durchlaßkurve des Tuners verändert wird. Fällt die festgestellte Bitfehlerrate unter den Grenzwert oder wird eine minimale Bitfehlerrate erreicht, wird die Anpassung beendet und der letze Abgleichwert bzw. Korrekturwert im Speicher 11 für den jeweiligen Kanal gespeichert.

Neben der bisher beschriebenen Anpassung des Tuners an individuelle Betriebsbedingungen mittels der Veränderung nur des Abgleichwerts des Vorkreises 2, ist es prinzipiell auch möglich, einen der anderen Abgleichwerte (Bandfilter 5 oder Oszillator 14) zu verändern, um den Tuner den individuellen Betriebsbedingungen anzupassen. Die Veränderung des Abgleichwerts des Vorkreises 2 ist aber besonders vorteilhaft, da durch die Änderung der Durchlaßkurve des Vorkreises 2 die resultierende Durchlaßkurve des Tuners am besten beeinflußt werden kann.

Ebenso ist es auch möglich, neben der Bestimmung von Korrekturwerten für jeden Kanal, nur Korrekturwerte für jeden n-ten Kanal zu bestimmen und für die dazwischenliegenden Kanäle die Korrekturwrete mittels einer Interpolation zu ermitteln.

## Patentansprüche

1. Tuner für den Empfang digitaler Signale, insbesondere digitaler Rundfunk- oder Fernsehsignale, mit
- mehreren unabhängig voneinander abstimmbaren Reaktanzelementen,
- einem Speicher (11), der für alle empfangbaren Kanäle vorgegebene Abgleichwerte für die Reaktanzelemente enthält,
- einer Steuereinheit (50) zur Steuerung des Tuners, und
- einer Bedieneinheit (60) zur Bedienung des Tuners,
**dadurch gekennzeichnet,**
daß mittels Bedieneinheit (60) und Steuereinheit (50) die vorgegebenen Abgleichwerte für ein Reaktanzelement geändert und im Speicher (11) als Korrekturwerte gespeichert werden können.

2. Tuner nach Anspruch 1,
**dadurch gekennzeichnet,**
daß die Korrekturwerte für das Reaktanzelement des Vorkreises (2) geändert und gespeichert werden.

3. Tuner nach Anspruch 1 oder 2,
**dadurch gekennzeichnet,**
daß im Speicher (11) zusätzlich zu den vorgegebenen Abgleichwerten die Differenz zwischen vorgegebenem Abgleichwert und Korrekturwert gespeichert wird, und daß bei einem erneuten Abgleich der Abgleichwert aus der Summe des vorgegebenen Abgleichwerts und der Differenz gebildet wird.

4. Tuner nach einem der Ansprüche 1 bis 3,
**dadurch gekennzeichnet,**
daß eine Einrichtung zur Ermittlung der Bitfehlerrate des digitalen Signals vorhanden ist, und daß die Steuereinheit (50) bei Überschreiten eines vorgegebenen Grenzwerts für die Bitfehlerrate die Ermittlung und Speicherung der Korrekturwerte durchführt.
